(19) Europäisches Patentamt
European Patent Office
Office européen des brevets

(11) Publication number: **0 475 086 A1**

# (12) EUROPEAN PATENT APPLICATION

(21) Application number: **91113382.5**

(22) Date of filing: **09.08.91**

(51) Int. Cl.[5]: **G03F 7/038**, C08G 18/81, C08G 73/10

(30) Priority: **12.09.90 JP 239862/90**

(43) Date of publication of application:
**18.03.92 Bulletin 92/12**

(84) Designated Contracting States:
**DE GB**

(71) Applicant: **HITACHI, LTD.**
**6, Kanda Surugadai 4-chome**
**Chiyoda-ku, Tokyo 101(JP)**
Applicant: **Hitachi Chemical Co., Ltd.**
**1-1, Nishishinjuku 2-chome**
**Shinjuku-ku, Tokyo 160(JP)**

(72) Inventor: **Kataoka, Fumio**
**Hachimanyama Apato 544, 1545, Yoshidacho**
**Totsuka-ku, Yokohama-shi(JP)**
Inventor: **Shoji, Fusaji**
**Higashinomachi 4-407, 525-1, Shinanocho**
**Totsuka-ku, Yokohama-shi(JP)**
Inventor: **Obara, Isao**
**15-14, Imaizumidai-1-chome**
**Kamakura-shi(JP)**
Inventor: **Kikkawa, Haruhiko**
**Adin Totsuka II-306,1957 Kamikuratacho**
**Totsuka-ku,**
**Yokohama-shi,244,Kanagawaken(JP)**

(74) Representative: **Dost, Wolfgang,**
**Dr.rer.nat.,Dipl.-Chem. et al**
**Patent- & Rechtsanwälte Bardehle .**
**Pagenberg . Dost . Altenburg . Frohwitter .**
**Geissler & Partner Galileiplatz 1 Postfach 86 06 20**
**W-8000 München 86(DE)**

## (54) Photo-sensitive polymer composition.

(57) A photo-sensitive polymer composition comprising (a) a polymer obtained by reacting a poly(amic acid) with one or more amino compounds having at least one hydroxyl group and an isocyanate compound, and (b) one or more photosensitizers, photoinitiators or photocrosslinkers can provide a polyimide film excellent in heat resistance and mechanical properties and is suitable for forming fine patterns.

EP 0 475 086 A1

## BACKGROUND OF THE INVENTION

This invention relates to a photo-sensitive polymer composition for forming fine patterns in semiconductor elements, multi-layer wiring substrates, microelectronics, and the like, and particularly suitable for a negative-type photo-sensitive material wherein exposed portions are cured.

Heretofore, as photo-sensitive heat resistant composition for giving heat resistant polymers, there have been reported (i) a composition containing a polymer obtained by producing an aromatic tetracarboxylic acid disester, which is then, together with a diamine, subjected to dehydration condensation polymerization reaction using carbodiimide (Japanese Patent Unexamined Publication No. 60-228537), and (ii) a composition comprising a polymer obtained by copolymerizing an aromatic tetracarboxylic dianhydride, an aromatic diamine and an aliphatic diamine containing a siloxane skeleton to give a poly(amic acid), and modifying the poly(amic acid) with isocyanate organo(meth)acrylate, and a photopolymerization initiator (Japanese Patent Unexamined Publication No. 60-100143). These compositions are dissolved in a suitable organic solvent to give varnishes, which are coated on substrates, dried to form coating films, exposed to ultraviolet light via a suitable photomask, if necessary, followed by development, subjected to a rinsing treatment to obtain desired relief patterns, which are heated to finally obtain cured film patterns.

But the composition (i) is low in mechanical properties such as flexibility and tensile strength as the finally cured film, so that cracks easily take place on the cured film. Particularly, when the composition (i) is used as interlevel insulating films, it is difficult to prevent the generation of cracks. The generation of cracks in the finally cured film seems to be caused by the fact that since the olefin aromatic tetracarboxylic acid diester has bulky olefinic ester residues neighboring to carboxyl groups, the polymerization does not proceed sufficiently at the time of dehydration polycondensation with the diamine, resulting in giving the low molecular weight polymer.

On the other hand, finally cured film obtained from the composition (ii) is relatively good in mechanical properties due to introduction of a photo-sensitive group into the high-polymeric poly(amic acid), but low in sensitivity. The low sensitivity causes various problems in that the productivity is low due to a long period of irradiation with ultraviolet light, the storage stability of varnish is low, which results in causing changes in properties, when a poly(amic acid) synthesized only by aromatic monomers is used at the time of modification with an isocyanate compound, the varnish is easily gelled and failed to be used, the modification should be carried out by using only a compound having a siloxane skeleton, etc. The easy gellation and low sensitivity of varnish of the composition (ii) seems to be that since the isocyanate compound not only reacts with the carboxylic acid of poly(amic acid) but also acts as a dehydrating agent, an imide ring is formed in the polymer to make the polymer insoluble in a solvent and the introducing rate of photo-sensitive group is lowered due to the consumption of carboxyl groups by the imidization. Further, the low stability of the varnish seems to be caused by low reactivity of the isocyanate compound and the poly(amic acid), resulting in retaining unreacted isocyanate compound after the synthesis, said unreacted isocyanate compound gradually reacting in a long period of time.

## SUMMARY OF THE INVENTION

It is an object of the present invention to provide a photo-sensitive heat resistant polymer composition capable of forming a finally cured film excellent in mechanical properties with high sensitivity, overcoming the above-mentioned defects.

The present invention provides a photo-sensitive polymer composition for forming fine patterns comprising

(a) a polymer obtained by reacting a poly(amic acid) having as a major component repeating units of the formula:

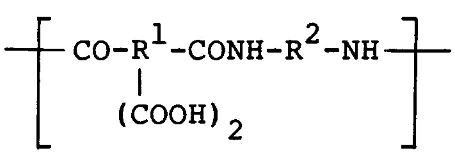

(1)

wherein $R^1$ is a tetravalent organic group having at least 4 carbon atoms; and $R^2$ is a divalent organic group, with one or more amino compounds having at least one hydroxyl group and an isocyanate compound having at least one carbon-carbon unsaturated bonding, and

(b) one or more photosensitizers, or photoinitiators, or photocrosslinkers.

DESCRIPTION OF THE PREFERRED EMBODIMENTS

The photo-sensitive heat resistant polymer composition of the present invention can give a varnish good in storage stability and a finally cured film excellent in mechanical properties. Further the photo-sensitive heat resistant polymer composition of the present invention may further contain a photosensitizing auxiliary or a photopolymerization auxiliary in order to adjust photo-sensitive properties and storage stability of varnish, and/or one or more copolymerizable monomers, polymerization inhibitors, stabilizers, etc. in order to impart other good physical and chemical properties.

According to the present invention, since one or more amino compounds having at least hydroxyl group is used at the reaction of an isocyanate compound having at least one carbon-carbon unsaturated bonding with a poly(amic acid), photo-sensitive groups can be introduced into a high polymeric poly(amic acid) effectively. Further, since the high polymeric poly(amic acid) is used, the finally cured film is excellent in mechanical properties. In addition, since the amino group of the amino compound having at least one hydroxyl group not only accelerate the reaction between the carboxyl group and the isocyanate group but also reacts the isocyanate group with the hydroxyl group effectively, the isocyanate compound can be removed from the reaction system, resulting in attaining high sensitivity and stability of varnish. The reaction product of the isocyanate compound and the amino compound having at least one hydroxyl group is an amine compound having at least one carbon-carbon unsaturated bonding, it can be introduced into the poly-(amic acid) by ionic bonding with the carboxyl group of the poly(amic acid), resulting in improving the introducing rate of the photo-sensitive group and attaining high sensitivity.

The photo-sensitive polymer composition for forming fine patterns comprises

(a) a polymer obtained by the reaction of a poly(amic acid) having as a major component repeating units of the formula:

$$\left[ \begin{array}{l} CO-\underset{\displaystyle (COOH)_2}{\underset{|}{R^1}}-CONH-R^2-NH \end{array} \right] \qquad (1)$$

wherein $R^1$ is a tetravalent organic group having at least 4 carbon atoms and $R^2$ is a divalent organic group, with one or more amino compounds having at least one hydroxyl group in an amount of preferably 1 to 400 parts by weight, and an isocyanate compound having at least one carbon-carbon unsaturated bonding in an amount of preferably 1 to 400 parts by weight, per 100 parts by weight of the poly(amic acid), and

(b) one or more photosensitizers, or photoinitiators, or photocrosslinkers.

The poly(amic acid) having repeating units of the formula (1) can be synthesized by reacting an acid dianhydride with a diamine compound.

Preferable examples of $R^1$ in the formula (1) are

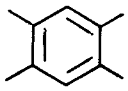, 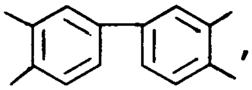, 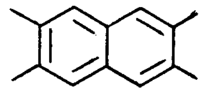, 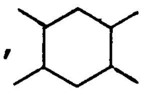,

$>CH-CH_2-CH_2-CH<$, or 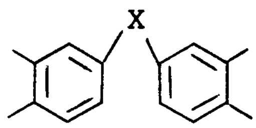 ; X is -O-, -CO-,

$-SO_2-$, $-CH_2-$, $-C(CH_3)_2-$, $-C(CF_3)_2$, 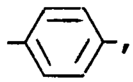, 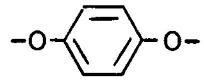,

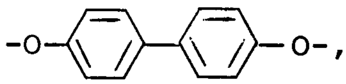, 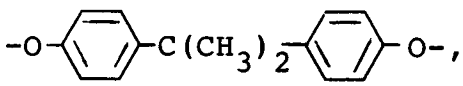, or

$-OCH_2CH_2O-$.

Preferable examples of $R^2$ in the formula (1) are

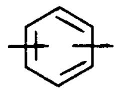, 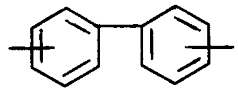, 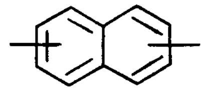, 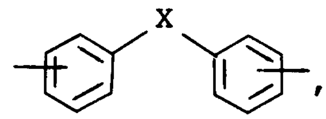,

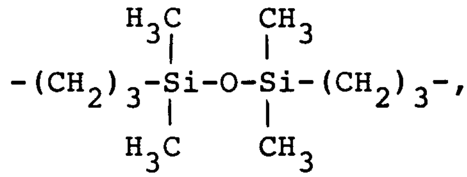, 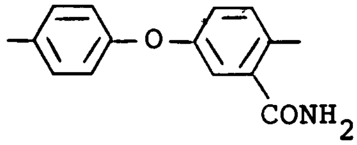,

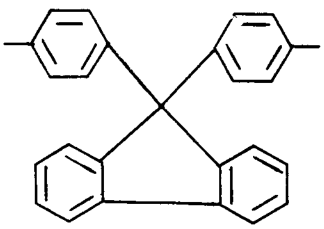, or 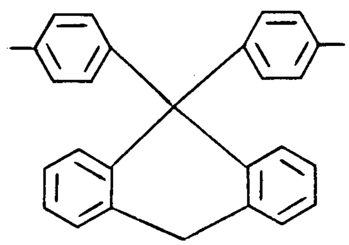 ; and X is

$-O-$, $-S-$, $-CO-$, $-CH_2-$, $-SO_2-$, $-C(CH_3)_2$, $-C(CF_3)_2-$,

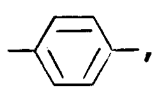, 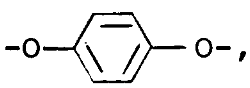, 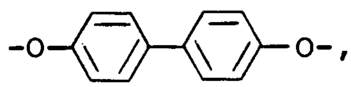,

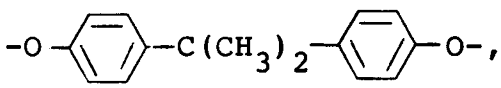, 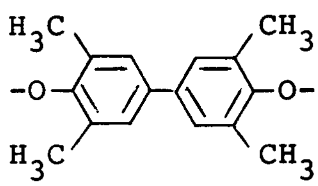, or

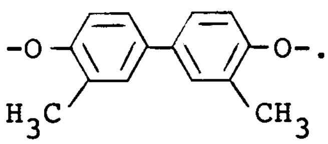.

The poly(amic acid) has preferably a number average molecular wieght of about 10,000 to 100,000.

As the amino compound having at least one hydroxy group, there can be used at least one amino compound selected from the group consisting of

$R^3R^4N-R^5OH$ (2)

and

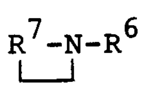 (3)

wherein $R^3$ and $R^4$ are independently hydrogen, an alkyl group, a phenyl group, a benzyl group, or $-R^5OH$; $R^5$ is a divalent organic group such alkylene, alkyl substituted alkylene, phenyl substituted alkylene, hydroxy substituted alkylene, alkoxy substituted alkylene, oxyalkylene, etc.; $R^6$ is hydrogen, an alkyl group, a phenyl group, a benzyl group, or $-R^5OH$; $R^7$ is the same as $R^5$ and is a divalent organic group forming a cyclic amino moiety with a nitrogen atom, and one or both of $R^5$ and $R^7$ can be substituted with at least one

hydroxyl group.

Preferable examples of the formulae (2) and (3) are as follows: 2-dimethylaminoethanol, 3-dimethylamino-1-propanol, 4-dimethylamino-1-butanol, 5-dimethylaminopentanol, 6-dimethylamino-1-hexanol, 2-dimethylamino-2-methyl-1-propanol, 3-dimethylamino-2,2-dimethyl-1-propanol, 2-diethylaminoethanol, 3-diethylamino-1-propanol, 2-diisopropylaminoethanol, 2-di-n-butylaminoethanol, N,N-dibenzyl-2-aminoethanol, 2-(2-dimethylaminoethoxy)ethanol, 2-(2-diethylaminoethoxy)ethanol, 1-dimethylamino-2-propanol, 1-diethylamino-2-propanol, 1-methyl-3-piperidinol, 1-methyl-4-piperidionol, N-ethyl-3-hydroxypiperidine, 1-methyl-4-piperidinemethanol, 1-methyl-3-piperidinemethanol, N-(2-hydroxyethyl)piperidine, N-(2-hydroxyethyl)morpholine, N-(2-hydroxypropyl)morpholine, N-(2-hydroxyethyl)-ethyleneimine, N-methyldiethanolamine, N-ethyldiethanolamine, N-n-butylethanolamine, N-t-butylethanolamine, N-lauryldiethanolamine, 3-diethylamino-1,2-propanediol, N-(2-hydroxyethyl)-4-(3-hydroxypropyl)piperidine, triethanolamine, triisopropanolamine, N-methylethanolamine, N-ethylethanolamine, N-n-butylethanolamine, N-cyclohexylethanolamine, 3-hydroxypiperidine, 4-hydroxypiperidine, 4-(2-hydroxyethyl)-piperidine, 2-piperidinemethanol, diethanolamine, diisopropanolamine, 2-aminoethanol, 3-amino-1-propanol, 4-amino-1-butanol, 6-amino-1-hexanol, 1-amino-2-propanol, 2-amino-2,2-dimethyl-1-propanol, 1-aminobutanol, 2-amino-1-butanol, N-(2-aminoethyl)ethanolamine, 2-amino-2-methyl-1,3-propanediol, 2-amino-2-ethyl-1,3-propanediol, 3-amino-1,2-propanediol, 2-amino-2-hydroxymethyl-1,3-propanediol, etc.

More preferable examples are as follows: 2-dimethylaminoethanol, 3-dimethylamino-1-propanol, 4-dimethylamino-1-butanol, 5-dimethylaminopentanol, 6-dimethylamino-1-hexanol, 2-dimethylamino-2-methyl-1-propanol, 3-dimethylamino-2,2-dimethyl-1-propanol, 2-diethylaminoethanol, 3-diethylamino-1-propanol, 2-diisopropylaminoethanol, 2-(2-dimethylaminoethoxy)ethanol, 2-(2-diethylaminoethoxy)ethanol, 1-dimethylamino-2-propanol, 1-diethylamino-2-propanol, 1-methyl-3-piperidinol, 1-methyl-4-piperidinol, N-ethyl-3-hydroxypiperidine, 1-methyl-4-piperidinemethanol, 1-methyl-3-piperidinemethanol, N-(2-hydroxyethyl)piperidine, N-methyl-diethanolamine, N-ethyldiethanolamine, 3-diethylamino-1,2-propanediol, N-(2-hydroxyethyl)-4-(3-hydroxypropyl)piperidine, triethanolamine, triisopropanolamine, are more prefered.

The amino compound having at least one hydroxy group can be used in an amount of preferably 1 to 400 parts by weight, more preferably 20 to 200 parts by weight, based on 100 parts by weight of the poly(amic acid). When the amount of the amino compound is less than 1 part by weight, both the photosensitivity of the composition and the reaction of the poly(amic acid) with the amino compound and the isocyanate compound are badly affected.

On the other hand, if the amount of is too large, the reaction often gives a gel during the synthesis, while the amount of the isocyanate is too small, the amount of photocrosslinked chains is so small that the portions exposed to light are undesirably easily released into a developing solution.

The addition of a too large amount of the amino compound also affects undesirably on the characteristics of the composition. When the amount of it is more than 100 parts by weight and the amount of the isocyanate is too large, the resulting polyimide film is lowered in the heat resistance. On the other hand, when the amount of isocyanate is too small, the photosensitivity of the composition and the stability of the varnish are lowered greatly.

As the isocyanate compound having at least one carbon-carbon unsaturated bonding, there can be used a compound of the formula:

$$R^8R^9C=C(R^{10})-CO_2-R^{11}-N=C=O \qquad (4)$$

wherein $R^8$, $R^9$ and $R^{10}$ are independently hydrogen, an alkyl group, a phenyl group, a vinyl group, or a propenyl group; and $R^{11}$ is a divalent organic group such as an alkylene group.

Preferable examples of the isocyanate compounds are as follows: 2-(methacryloyloxy)ethyl isocyanate, 3-(methacryloyloxy)propyl isocyanate, 4-(methacryloyloxy)butyl isocyanate, 5-(methacryloyloxy)pentyl isocyanate, 6-(methacryloyloxy)hexyl isocyanate, 2-(acryloyloxy)ethyl isocyanate, 3-(acryloyloxy)propyl isocyanate, 4-(acryloyloxy)butyl isocyanate, 5-(acryloyloxy)pentyl isocyanate, 6-(acryloyloxy)hexyl isocyanate, 2-(2,4-pentadienoyloxy)ethyl isocyanate, 3-(2,4-pentadienoyloxy)propyl isocyanate. These compounds may be used alone or as a mixture thereof.

The compounds with methacryloyloxy and acryloyloxy group are favorable because of their high photoreactivities. Among them, 2-(methacryloyloxy)ethyl isocyanate and 2-(acryloyloxy)ethyl isocyanate are more preferred, since the molecular weights are smaller and hence, after the pattern formation, they are

removed easily by the final heat treatment, resulting in high heat resistance of the produced polyimide.

The isocyanate compound can be used in an amount of preferably 1 to 400 parts, more preferably 20 to 200 parts by weight, per 100 parts by weight of the poly(amic acid). When the amount is less than the above-mentioned widest range, photosensitivity is lowered, or developability have many restrictions. When the amount is particularly large, there is brought about a bad effect on the heat resistance of the resulting polyimide and the stability of the varnish as well as many restrictions on development.

The polymer (a) obtained from the following monomers, i.e.

$$-\!\!\left[ CO-\underset{(COOH)_2}{\underset{|}{R^1}}-CONH-R^2-NH \right]\!\!- \qquad (1),$$

$$R^8R^9C=\overset{R^{10}}{\overset{|}{C}}-\overset{O}{\overset{||}{C}}-O-R^{11}-N=C=O \qquad (4),$$

and

$R^3R^4N-R^6-OH$ (2)

can be, for example, represented by the formula:

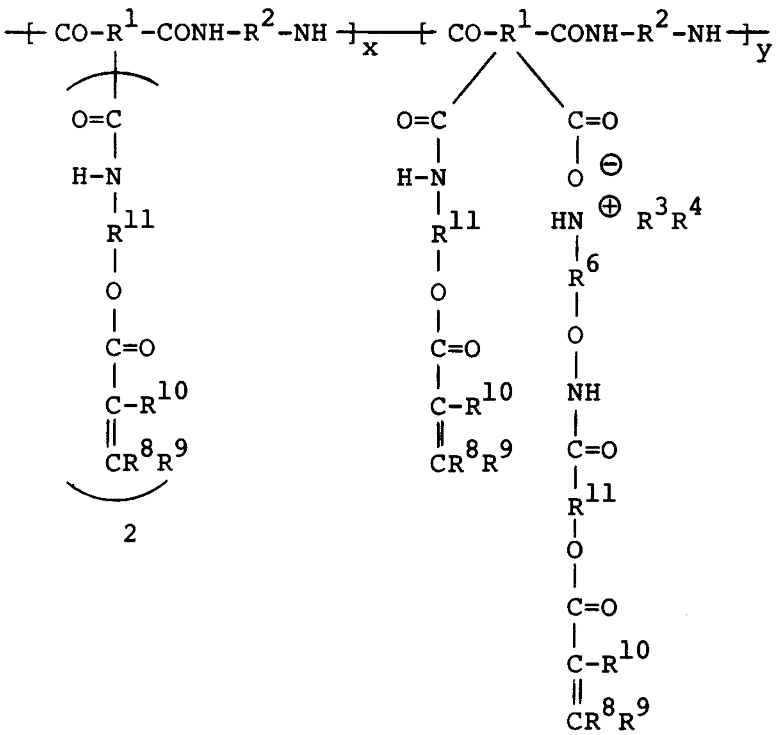

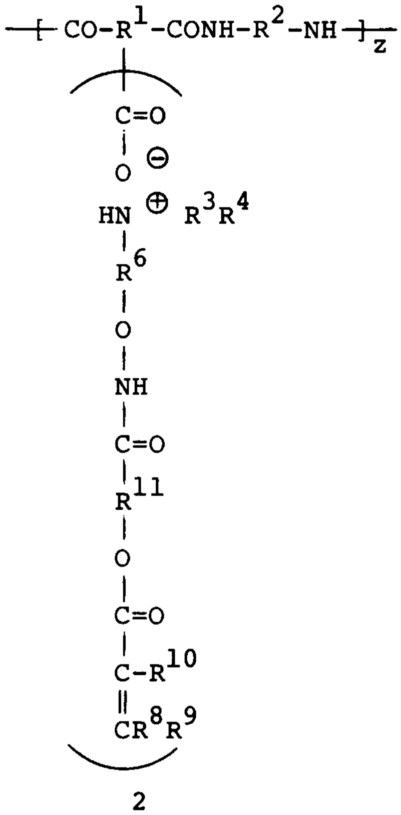

(5)

wherein x, y and z are ratios of repeatings units. The number average molecular weight of the polymer of the formula (5) is about 10,000 to 300,000.

On the other hand, when the following monomers, i.e.

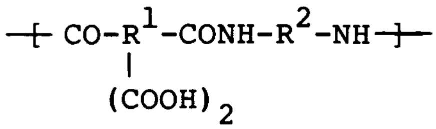

(1),

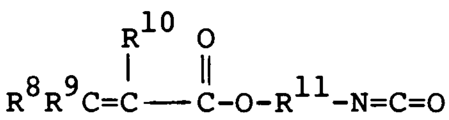

(4), and

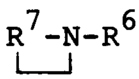

(3),

more in detail,

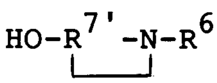

(3') or

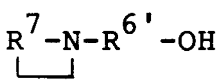

(3")

are used, the resulting polymer can be represented by the formula (6') or (6"):

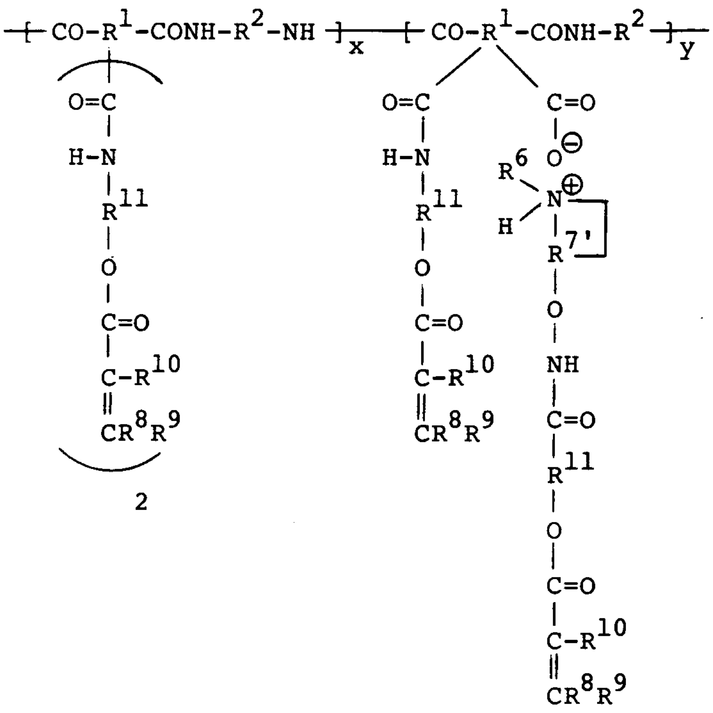

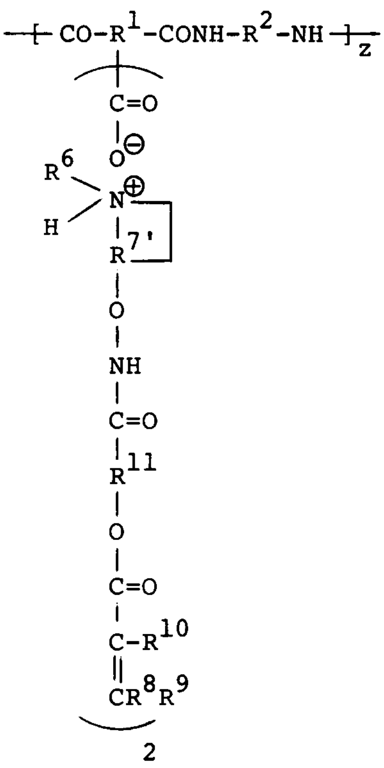

(6')

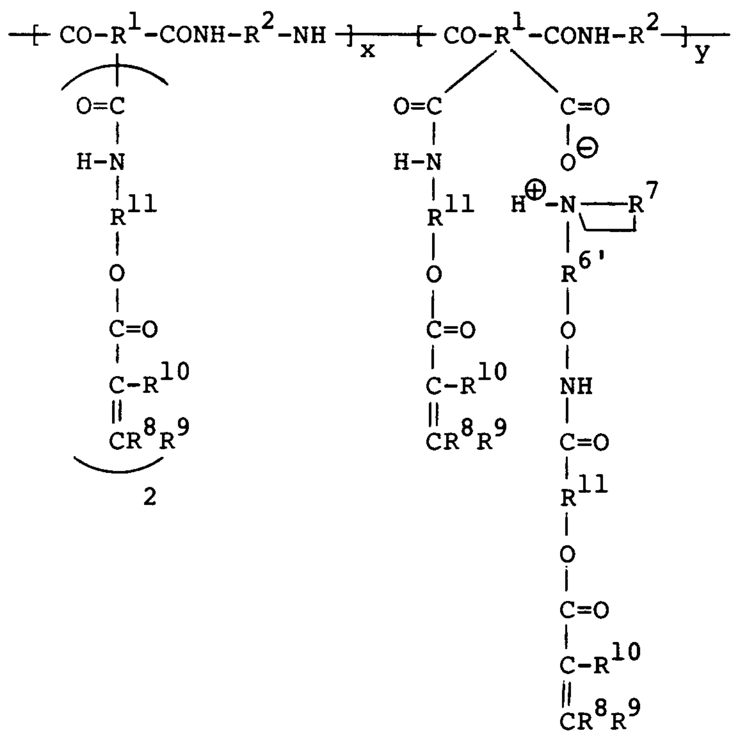

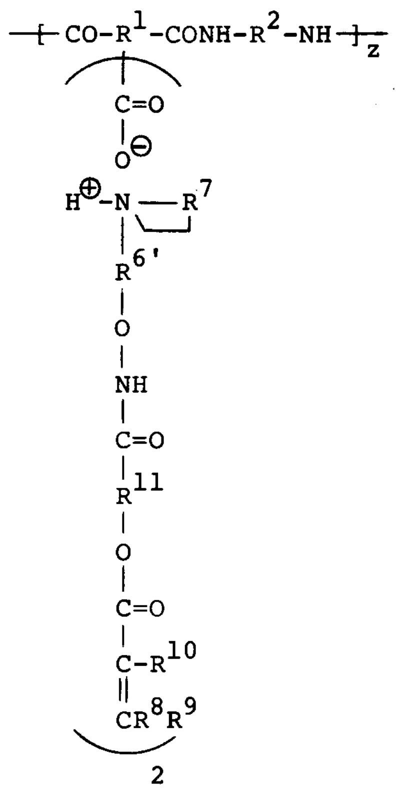

(6")

In the formulae (6') and (6"), x, y and z are ratios of repeatings units. the number average molecular weight of the polymer of the formula (6') or (6") is about 10,000 to 300,000.

In the formulae (5), (6') and (6"), the values of x, y, and z are preferably

x = 0.5 to 99
y = 0.5 to 99
z = 0.5 to 99, and
x + y + z = 100.

In the reaction of the poly(amic acid) with the amino compound having at least one hydroxy group and the isocyanate compound, two synthetic methods can be available. One method is to add the isocyanate to a mixture of the poly(amic acid) and the amino compound dissolved in an aprotic polar solvent and reacted at 80 ° C or lower, preferably 25 ° C or lower, more preferably under cooling. Another method is to add the amino compound to a mixture of the poly(amic acid) and the isocyanate compound dissolved in an aprotic polar solvent and reacted at 80 ° C or lower, preferably 25 ° C or lower, more preferably under cooling.

The photosensitive polymer composition of this invention contains one or more photosensitizers, photoinitiators, or photocrosslinkers to obtain efficient photosensitivities.

Preferable examples of the photosensitizers, photoinitiators, or photocrosslinkers are as follows: Michler's ketone, bis-4,4'-diethylaminobenzophenone, benzophenone, 3,5-bis(4'-diethylaminobenzylidene)-N-methyl-piperidone, 3,5-bis(4'-dimethylaminobenzylidene)-N-methyl-piperidone, 2,6-bis(4'-dimethylaminobenzylidene)-4-carboxycyclohexanone, 2,6-bis(4'-dimethylaminobenzylidene)-4-hydroxycyclohexanone, 2,6-bis-(4'-diethylaminobenzylidene)-4-carboxycyclohexanone, 2,6-bis(4'-diethylaminobenzylidene)-4-hydroxycyclohexanone, 2,6-bis(4'-dimethylaminobenzylidene)-4-hydroxymethylcyclohexanone, 2,6-bis(4'-diethylaminobenzylidene)-4-hydroxymethylcyclohexanone, 3,3'-carbonyl bis(7-diethylamino)coumarin, 7-diethyamino-4-methylcoumarin, 3-(2-benzothiazolyl)-7-diethyaminocoumarin, 3-(2-benzimidazolyl)-7-diethyaminocoumarin, 2-(p-dimethylaminostyryl)quinoline, 4-(p-dimethylaminostyryl)quinoline, 2-(p-dimethylaminostyryl)benzothiazole, 2-(p-dimethylaminostyryl)benzoxazole, 2-(p-dimethylaminostyryl)-3,3'-dimethyl-3H-indole, riboflavine tetrabutyrate, 2-methyl-1-[4-(methylthio)phenyl]-2-morphorinopropane-1-one, 2,4-dimethylthioxantone, 2,4-diethylthioxantone, 2,4-diisopropylthioxantone, 3,5-diisopropylthioxantone, 3,5-dimethylthioxantone, thioxanten-9-one, 1-phenyl-5-mercapto-1H-tetrazole, 3-acetylindole, benzoin ethyl ether, benzoin isopropyl ether, 1,9-benzanthrone, 5-nitroacenaphthene, 2-nitrofluorene, anthanthrone, 1,2-benzanthraquinone, 2,6-bis(4'-azidobenzylidene)cyclohexanone, 2,6-bis(4'-azidobenzylidene)-4-methylcyclohexanone, 2,6-bis(4'-azidobenzylidene)-4-carboxycyclohexanone, 2,6-bis(4'-azidobenzylidene)-4-hydroxycyclohexanone, 3,5-bis(4'-azidobenzylidene)-N-methyl-piperidone, 2,6-bis(4'-azidocinnamylidene)-4-carboxycyclohexanone, 2,6-bis(4'-azidocinnamylidene)-4-hydroxycyclohexanone, etc.

Amont them, more preferable examples are as follows: Michler's ketone, bis-4,4'-diethylaminobenzophenone, 3,5-bis(4'-diethylaminobenzylidene)-N-methyl-piperidone, 3,5-bis(4'-dimethylaminobenzylidene)-N-methyl-piperidone, 2,6-bis(4'-dimethylaminobenzylidene)-4-carboxycyclohexanone, 2,6-bis(4'-dimethylaminobenzylidene)-4-hydroxycyclohexanone, 2,6-bis(4'-diethylaminobenzylidene)-4-carboxycyclohexanone, 2,6-bis(4'-diethylaminobenzylidene)-4-hydroxycyclohexanone, 2,6-bis(4'-dimethylaminobenzylidene)-4-hydroxymethylcyclohexanone, 2,6-bis(4'-diethylaminobenzylidene)-4-hydroxymethylcyclohexanone, 3,3'-carbonyl bis(7-diethylamino)coumarin, 7-diethyamino-4-methylcoumarin, 2-(p-dimethylaminostyryl)quinoline, riboflavine tetrabutyrate, 2-methyl-1-[4-(methylthio)phenyl]-2-morphorinopropane-1-one, 2,4-dimethylthioxantone, 2,4-diethylthioxantone, 2,4-diisopropylthioxantone, benzoin isopropyl ether, 5-nitroacenaphthene, 2,6-bis(4'-azidobenzylidene)-4-carboxycyclohexanone, 2,6-bis(4'-azidobenzylidene)-4-hydroxycyclohexanone, 2,6-bis(4'-azidocinnamylidene)-4-carboxycyclohexanone, and 2,6-bis(4'-azidocinnamylidene)-4-hydroxycyclohexanone.

By using these compounds, the efficiencies on photosensitization become greater. All of these compounds may be used alone or as a mixture thereof.

The amount of photosensitizer, photoinitiator, or photocrosslinker to be incorporate is preferably 0.1 to 30 parts, more preferably 0.3 to 20 parts by weight per 100 parts by weight of the poly(amic acid). When it is less than 0.1 part by weight, these compounds have little effect on photosensitization, while when it is more than 30 parts by weight, the resulting polyimide film is lowered in heat resistance or there is brought about many restrictions on development.

The photo-sensitive polymer composition of this invention may further contain, if necessary, one or more co-photosensitizers, crosslinking auxiliaries, stabilizers, or inhibitors for thermal polymerization.

The co-photosensitizer improves the photosensitivity by giving reactive radicals which are generated by the reaction with photoactivated photosensitizers or by decomposition reaction resulted from the energy transfer from the photoactivated photosensitizer.

Typical examples of the co-photosensitizers are as follows: ethyl 4-diethylaminobenzoate, ethyl 4-dimethylaminobenzoate, propyl 4-diethylaminobenzoate, propyl 4-dimethylaminobenzoate, isoamyl 4-dimethylaminobenzoate, N-phenylglycine, N-methyl-N-phenylglycine, N-(4-cyanophenyl)glycine, 4-dimethyaminobenzonitrile, ethylene glycol dithioglycolate, ethyleneglycol di(3-mercaptopropionate), trimethylolpropane thioglycolate, trimethylolpropane tri(3-mercaptopropionate), pentaerythritol tetrathioglycolate, pentaerythritol tetra(3-mercaptopropionate), trimethylolethane trithioglycolate, trimethylolpropane trithioglycolate, trimethylolethane tri(3-mercaptopropionate), dipentaerythritol hexa(3-mercaptopropionate), thioglycolic acid, $\alpha$-mercaptopropionic acid, 1,3-di(t-butyldioxycarbonyl)benzene, 3,3',4,4'-tetrakis(t-butyldioxycarbonyl)benzophenone, 3-phenylisoxazolone, 2-mercaptobenzimidazole, and the like.

Amont them, more preferable examples are as follows: ethyl 4-diethylaminobenzoate, ethyl 4-dimethylaminobenzoate, isoamyl 4-dimethylaminobenzoate, N-phenylglycine, N-methyl-N-phenylglycine, N-(4-cyanophenyl)glycine, 4-dimethyaminobenzonitrile, pentaerythritol tetrathioglycolate, pentaerythritol tetra-(3-mercaptopropionate), trimethylolethane trithioglycolate, trimethylolpropane trithioglycolate, trimethylolethane tri(3-mercaptopropionate), thioglycolic acid, $\alpha$-mercaptopropionic acid, 1,3-di(t-butyldioxycarbonyl)benzene, 3,3',4,4'-tetrakis(t-butyldioxycarbonyl)benzophenone, 3-phenylisoxazolone, and 2-mercaptobenzimidazole.

By using these compounds, there can be obtained higher efficiencies on photosensitization. These compounds may be used alone or as a mixture thereof.

The co-photosensitizer is preferably incorporated in an amount of preferably 0.1 to 30 parts, more preferably 0.3 to 20 parts by weight, per 100 parts by weight of the poly(amic acid). When it is less than 0.1 part by weight, these compounds have little effect on photosensitization, while when it is more than 30 parts by weight, there is brought about restrictions to the developability or a bad effect on the heat resistance of the finally produced polyimide.

Copolymerizable monomer having at least two photopolymerizable carbon-carbon double bonds may be used as crosslinking auxiliaries to improve the sensitivity or pattern formability.

Preferable example of the said compounds are as follows: 1,6-hexanediol diacrylate, neopentylglycol diacrylate, ethyleneglycol diacrylate, pentaerythritol diacrylate, trimethylolpropane triacrylate, pentaerythritol triacrylate, dipentaerythritol hexaacrylate, tetramethylolpropane tetraacrylate, tetraethyleneglycol diacrylate, 1,6-hexanediol dimethacrylate, neopentylglycol dimethacrylate, ethyleneglycol dimethacrylate, pentaerythritol dimethacrylate, trimethylolpropane trimethacrylate, pentaerythritol trimethacrylate, dipentaerythritol hexamethacrylate, tetramethylolpropane tetramethacrylate, tetraethyleneglycol dimethacrylate, and the like.

Among them, 1,6-hexanediol diacrylate, neopentylglycol diacrylate, ethyleneglycol diacrylate, pentaerythritol diacrylate, trimethylolpropane triacrylate, pentaerythritol triacrylate, dipentaerythritol hexaacrylate, tetramethylolpropane tetraacrylate, and tetraethyleneglycol diacrylate are more preferred because of higher reactivity on irradiation.

These compounds are preferably incorporated in an amount of preferably 1 to 100 parts, more preferably 3 to 50 parts by weight, per 100 parts by weight of the poly(amic acid). When it is less than 1 part by weight, these compounds have little effect on photosensitization, while when it is more than 100 parts by weight, there is brought about restrictions to the developability or a bad effect on the heat resistance of the final product polyimide.

The stabilizers, or polymerization inhibitors may be used to obtain thermal stability of the solution of the photosensitive polymer composition by inhibiting generation of radicals during storage.

Preferable examples of these compounds include hydroquinoe, p-methoxyphenol, N-nitrosodiphenylamine, p-t-butylcatechol, N-phenylnaphtylamine, ethylenediamine tetracarboxylic acid, 1,2-cyclohexanediamine tetracarboxylic acid, glycoletherdiamine-tetracarboxylic acid, 2,6-di-t-butyl-p-methylphenol, and the like.

The said compound is preferably incorporated in an amount of preferably 0.001 to 10 parts by weight, more preferably 0.01 to 5 parts by weight, per 100 parts by weight of the poly(amic acid). When it is less than 0.001 part by weight, these compounds have little effect on stabilization of the solution, while when it is more than 10 parts by weight, there is brought about restrictions to the developability.

The photo-sensitive polymer composition of this invention can be used in the form of solution dissolved in an aprotic polar solvent. As the aprotic polar solvent, there can preferably be used N-methyl-2-pyrrolidone, N-acetyl-2-pyrrolidone, N-benzyl-2-pyrrolidone, N,N-dimethylformamide, N,N-dimethylacetamide, dimethylsufoxide, hexamethylphosphoric triamide, N-acetyl-$\epsilon$-caprolactam, dimethylimidazolidinone, diethylenglycol dimethylether, triethyleneglycol dimethylether, and $\gamma$-butyrolactone are preferred. These may be used alone or as a mixture thereof.

The amount of aforementioned solvent to be incorporated is preferably 100 to 10,000 parts by weight per 100 parts by weight of the poly(amic acid). When it is outside of the above-mentioned range, there is a tendency to deteriorate the film-forming properties.

In addition to the aprotic polar solvent, aromatic solvents such as toluene, xylene, methoxybenzene, etc. can also be added, in an amount not to lower the solubility of the solvent, and to improve the leveling property of the solution.

In order to further improve the adhesion between a substrate and coating film formed thereon, an adhesion-improving agent, such as amino siloxane derivatives, can be added to the photo-sensitive polymer composition, or the substrate is treated by the adhesion-promoting agent such as aluminum triisopropoxide.

The photo-sensitive polymer composition of this invention permits pattern processing by a usual

microprocessing technique, using for example, ultraviolet rays.

For coating the substrate such as silicon wafers or ceramic plates having metal wirings and insulation layers thereon with the photo-sensitive polymer composition, there may be used processes such as a spin coating process using a spinner, an immersion, spray, printing or the like process, and these may properly be selected depending on purposes. The thickness of the coating film can be controlled by means of coating techniques, the solid content and the viscosity of a varnish of the composition.

The photosensitive polymer composition of this invention formed into a coating film on the substrate by drying after a deposition and a spin coating, is imagewisely exposed to light, after which unexposed portions are dissolved and removed by a developing solution, whereby a desired relief pattern can be obtained.

As the developing solution, there can be used aprotic polar solvents such as N-methyl-2-pyrrolidone, N-acetyl-2-pyrrolidone, N-benzyl-2-pyrrolidone, N,N-dimethylformamide, N,N-dimethylacetamide, dimethylsulfoxide, hexamethylphosphoric triamide, N-acetyl-$\epsilon$-caprolactam, dimethylimidazolidinone, diethylenglycol dimethylether, triethyleneglycol dimethylether, $\gamma$-butyrolactone, and the like, alone or as a mixture thereof. These may further be used in the form of a mixed solution with methanol, ethanol, isopropyl alcohol, tuluene, xylene, 1,2-dimethoxyethane, 2-methoxyethanol, 1-acetoxy-2-methoxyethane, water, or the like.

The relief pattern formed in the manner described above is washed out with a rinsing solution to remove the developing solution attached.

As the rinsing solution, there can be used a non-solvent for the poly(amic acid) which is miscible with the developing solution.

The polymer of the relief pattern obtained by the above-mentioned treatment is a precursor of polyimide. By subjecting the precursor to a heat treatment at 150°C to 450°C, there can be obtained a pattern of polyimide excellent in heat resistance and mechanical properties.

The present invention is illustrated by way of the following Examples, in which all parts and percents are by weight unless otherwise specified.

Example 1

An amine solution was prepared by dissolving 10 g (0.05 mole) of 4,4'-diaminodiphenyl ether in 179 g of a 1:1 mixed solution of N-methyl-2-pyrrolidone and N,N-dimethylacetamide under a nitrogen stream. To the resulting solution maintained at about 15°C by ice cooling, 10.9 g (0.05 mole) of pyromellitic dianhydride was added with stirring, followed by reaction at 15°C for 5 hours to give a poly(amic acid) solution having a viscosity of 20 poises (25°C).

To 20 g of the poly(amic acid) solution, 1.40 g (0.009 mole) of 2-(methacryloxy)ethyl isocyanate was added with ice cooling and reacted for 1 hour. Then, a solution obtained by dissolving 0.595 g (0.005 mole) of N-methyldiethanolamine in 0.5 g of N,N-dimethylacetamide was gradually added dropwise to the reaction solution at 20°C or lower, followed by additional reaction for 3 hours. Then, 20 mg of 2,6-di-tert-butylphenol was added to the reaction solution. The resulting solution was stable at room temperature for one week without gellation.

To the solution, 10 mg of 3,5-bis(4-diethylaminobenzylidene)-N-methylpiperidone and 100 mg of ethyl 4-diethylaminobenzoate were added, followed by filtration under pressure using a filter having pores of 5 $\mu$m in diameter.

The resulting solution was spin coated on a silicon wafer using a spinner, followed by drying at 90°C for 30 minutes to give a coated film of 4 $\mu$m thick. The coated film was covered with a photomask having a stripe pattern and exposed to ultraviolet light emitted from a 500 W high pressure mercury lamp. After the exposure to light, development was carried out using a developing solution containing N-methyl-2-pyrrolidone and water (4:1 by volume), followed by rinsing with isopropyl alcohol to give a relief pattern. After the development, the dependency of film thickness on the exposure dose was measured. The sensitivity, which was defined as an exposure dose making the film thickness after development half of the coated film thickness, was 120 mJ/cm$^2$. As a result, there was obtained a relief pattern of 5 $\mu$m wide having sharp edge profiles by the exposure dose of 4 times as large as the sensitivity. This pattern was heated at 200°C for 30 minutes and 400°C for 30 minutes to finally obtain a pattern of polyimide.

On the other hand, a polyimide film of 8 $\mu$m thick was obtained in the same manner as mentioned above except for not forming the pattern and subjected to measurement of elongation. The elongation was as good as 10%.

Example 2

To 20 g of the poly(amic acid) solution synthesized in Example 1, 0.595 g (0.005 mole) of N-methyldiethanolamine was added and reacted for one hour at room temperature. Then, 20 mg of 2,6-di-tert-butylphenol was added to the reaction solution, and a solution obtained by dissolving 1.40 g (0.009 mole) of 2-(methacryloyloxy)ethyl isocyanate in 1.5 g of N,N-dimethylacetamide was gradually added dropwise at 20°C or lower, followed by reaction for 3 hours. The resulting solution was stable at room temperature for one week without gellation.

To the resulting solution, 20 mg of 3,5-bis(4-diethylaminobenzylidene)-4-methyl-piperidone and 100 mg of pentaerythritol tetra(3-mercaptopropionate) were added and filtered under pressure using a filter having pores of 5 µm.

The resulting solution was spin coated on a silicon wafer using a spinner, followed by drying at 90°C for 30 minutes to obtain a coated film of 5 µm thick. The coated film was treated in the same manner as described in Example 1 to obtain a relief pattern. The sensitivity was 80 $mJ/cm^2$. There was obtained a relief pattern of 7 µm wide having sharp edge profiles by the exposure dose of 4 times as large as the sensitivity. This pattern was heated at 200°C for 30 minutes and 400°C for 30 minutes to finally obtain a pattern of polyimide.

On the other hand, a polyimide film of 8 µm thick was obtained in the same manner as mentioned above except for not forming the pattern and subjected to measurement of elongation. The elongation was as good as 10%.

Example 3

An amine solution was prepared by dissolving 10 g (0.05 mole) of 4,4'-diaminodiphenyl ether in 140 g of a 1:1 mixed solution of N-methyl-2-pyrrolidone and N,N-dimethylacetamide under a nitrogen stream. To the resulting solution maintained at about 15°C by ice cooling, 14.7 g (0.05 mole) of 3,3',4,4'-biphenyltetracarboxylic dianhydride was added with stirring, followed by reaction at 15°C for 5 hours to give a poly(amic acid) solution having a viscosity of 60 poises (25°C).

To 20 g of the poly(amic acid), 30 mg of 2,6-di-tert-butylphenol and 1.71 g (0.011 mole) of 2-(methacryloyloxy)ethyl isocyanate were added and reacted at room temperature for 1 hour. Then, a solution obtained by dissolving 1.07 g (0.012 mole) of 2-dimethylaminoethanol in 1.0 g of N,N-dimethylacetamide was gradually added dropwise to the reaction solution at 20°C or lower, followed by additional 3 hours' reaction. The resulting solution was stable at room temperature for one week without gellation.

To this solution, 40 mg of 3,4-diethylthioxanthone and 100 mg of ethyl 4-diethylaminobenzoate were added, followed by filtration under pressure using a filter having holes of 5 µm in diameter.

The resulting solution was spin coated on a silicon wafer using a spinner, followed by drying at 90°C for 30 minutes to obtain a coated film of 5 µm thick. The coated film was treated in the same manner as described in Example 1 to obtain a relief pattern. The sensitivity was 180 $mJ/cm^2$. There was obtained a relief pattern of 5 µm wide having sharp edge profiles by the exposure dose of 4 times as large as the sensitivity. This pattern was heated at 200°C for 30 minutes and 400°C for 30 minutes to finally obtain a pattern of polyimide.

On the other hand, a polyimide film of 8 µm thick was obtained in the same manner as mentioned above except for not forming the pattern and subjected to measurement of elongation. The elongation was as good as 15%.

Example 4

To 20 g of the poly(amic acid) solution synthesized in Example 3, 1.26 g (0.012 mole) of diethanolamine was added and reacted for 1 hour. Then, 30 mg of 2,6-di-tert-butylphenol was added to the reaction solution, followed by dropwise addition of a solution obtained by dissolving 1.86 g (0.024 mole) of 2-(methacryloyloxy)ethyl isocyanate in 2.0 g of N,N-dimethylacetamide to the reaction solution gradually at 20°C, followed by additional 3 hours' reaction. The resulting solution was stable at room temperature for one week without gellation.

To this solution, 60 mg of Michler's ketone and 150 mg of pentaerythritol tetra(3-mercaptopropionate) were added, and then subjected to filtration under pressure using a filter having pores of 5 µm in diameter.

The resulting solution was spin coated on a silicon wafer using a spinner, followed by drying at 90°C for 30 minutes to obtain a coated film of 5 µm thick. The coated film was treated in the same manner as described in Example 1 to obtain a relief pattern. The sensitivity was 60 $mJ/cm^2$. There was obtained a relief pattern of 5 µm wide having sharp edge profiles by the exposure dose of 4 times as large as the sensitivity. This pattern was heated at 200°C for 30 minutes and 400°C for 30 minutes to finally obtain a

pattern of polyimide.

On the other hand, a polyimide film of 8 µm thick was obtained in the same manner as mentioned above except for not forming the pattern and subjected to measurement of elongation. The elongation was as good as 15%.

Examples 5 to 20

Polymers were prepared by reacting a poly(amic acid) having repeating units of the formula (1), an amino compound having at least one OH group and represented by the formula (2) or (3), and an isocyanate compound having at least one carbon-carbon double bond and represented by the formula (4) in the same manner as described in Examples 1 and 2. In the synthetic method (A), the poly(amic acid) and the isocyanate compound were reacted first, and in the synthetic method (B), the poly(amic acid) and the amino compound were reacted first.

The stability of varnish was measured by allowing a varnish added with 1 part of 2,6-di-tert-butylphenol at room temperature for one week and evaluated as "good" when no gellation took place.

The concentration of poly(amic acid) was 10 to 15%, and as the solvent there was used a 1:1 mixed solution of N-methyl-2-pyrrolidone and N,N-dimethylacetamide.

Table 1

| Example No. | Polymer No. | Synthetic method | Poly(amic acid) (1) | | |
|---|---|---|---|---|---|
| | | | $R^1$ | $R^2$ | Parts |
| 5 | P-1 | A | 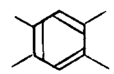 | 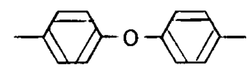 | 100 |
| 6 | P-2 | A | do. | do. | 100 |
| 7 | P-3 | A | 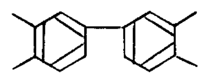 | do. | 100 |
| 8 | P-4 | A | 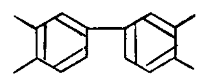 | do. | 100 |
| 9 | P-5 | A | 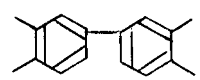 | 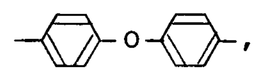, 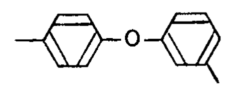 (1:1) | 100 |
| 10 | P-6 | A | 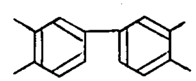 | 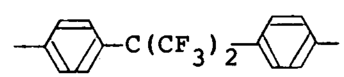 | 100 |

- to be cont'd -

- cont'd -

| Amino compound having OH group (2) or (3) (parts) | Isocyanate (4) (parts) | Stability |
|---|---|---|
| $(HOCH_2CH_2)_2NC_2H_5$ (56) | $H_2C=C(CH_3)-CO_2CH_2CH_2NCO$ (100) | Good |
| $HO(CH_2)_2NC_2H_5$ (32) | do. (59) | do. |
| $HO(CH_2)_2O(CH_2)_2N(CH_3)_2$ (54) | do. (56) | do. |
| $CH_3CH(OH)CH_2N(CH_3)_2$ (42) | do. (30) | do. |
| 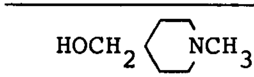 (52) | do. (63) | do. |
| $HO(CH_2)_2O(CH_2)_2N(CH_3)_2$ (42) | do. (29) | do. |

- cont'd -

| | | | | | |
|---|---|---|---|---|---|
| 11 | P-7 | A | 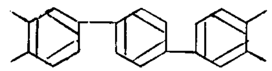 | 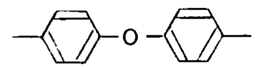 , 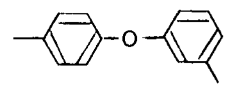 (1:1) | 100 |
| 12 | P-8 | A | 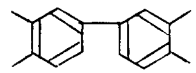 | 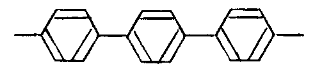 | 100 |
| 13 | P-9 | A | 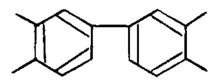 | 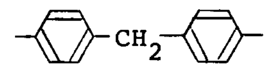 | 100 |
| 14 | P-10 | B | 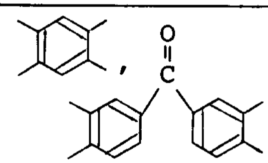 , (1:1) | 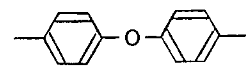 | 100 |
| 15 | P-11 | B | do. | do. | 100 |
| 16 | P-12 | B | 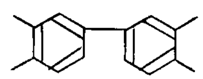 | do. | 100 |

- to be cont'd -

- cont'd -

| | | |
|---|---|---|
| $(HOCH_2CH_2)_3N$ (52) | $H_2C=C(CH_3)-CO_2CH_2CH_2NCO$ (130) | Good |
| $HO(CH_2)_2O(CH_2)_2N(CH_3)_2$ (48) | do. (35) | do. |
| $HO(CH_2)_3N(CH_3)_2$ (48) | do. (50) | do. |
| $(HOCH_2CH_2)_2NC_2H_5$ (56) | do. (100) | do. |
| $HO(CH_2)_2NHCH_3$ (32) | do. (59) | do. |
| $HO(CH_2)_2O(CH_2)_2N(CH_3)_2$ (54) | do. (56) | do. |

- to be cont'd -

- cont'd -

| | | | | | |
|---|---|---|---|---|---|
| 17 | P-13 | B | 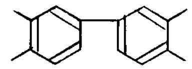 | 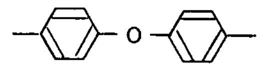 | 100 |
| 18 | P-14 | B | 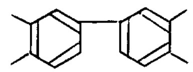 | 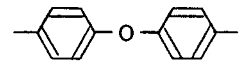 , 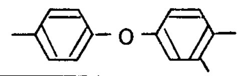 (1:1) | 100 |
| 19 | P-15 | B | 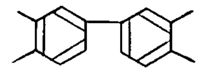 , 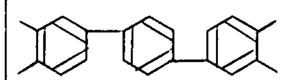 (1:1) | 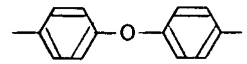 , 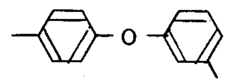 (1:1) | 100 |
| 20 | P-16 | B | 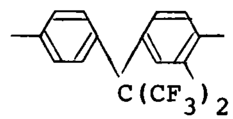 | 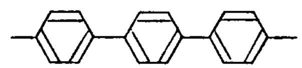 , 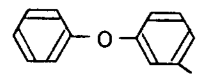 (1:1) | 100 |

- to be cont'd -

- cont'd -

| | | |
|---|---|---|
| $CH_3CH(OH)CH_2N(CH_3)_2$ (42) | $H_2C=C(CH_3)-CO_2CH_2CH_2NCO$ (50) | good |
| $HOCH_2CH_2NH_2$ (22) | do. (45) | do. |
| $HO(CH_2)_2O(CH_2)_2N(CH_3)_2$ (150) | do. (50) | do. |
| $(HOCH_2CH_2)_3N$ (53) | $H_2C=C(H)-CO_2CH_2CH_2NCO$ (100) | do. |

Examples 21 to 40

Photo-sensitive polymer compositions were prepared by using a polymer as shown in Table 1 and additives as shown in Table 2. The film-forming conditions and evaluating conditions were the same as described in Examples 1 to 4. The film thickness was set at 5 to 20 $\mu$m.

The sensitivity of 300 mJ/cm$^2$ or less when measured at a wavelength of 365 nm was evaluated as "good". Further, the elongation of the final polyimide of 5% or more was evaluated as "good".

Table 2

| Example No. | Polymer No. (Parts of poly(amic acid)) | Photosensitizer, photoinitiator, or photocrosslinker (parts) | Co-photosensitizer (parts) |
|---|---|---|---|
| 21 | P-6 (100) | Michler's ketone (20) | Pentaerythritol tetrathioglycolate (5) |
| 22 | P-5 (100) | 2,6-Bis(4'-azido-benzylidene)-4-carboxycylohexanone (5) | - |
| 23 | P-7 (100) | 3,5-Dimethylthio-xanthone (2) | Ethyl 4-diethyl-aminobenzoate (5) |
| 24 | P-8 (100) | 3,3'-Carbonyl bis(7-dimethylamino)-coumarin (2) | do. (8) |
| 25 | P-9 (100) | 3,5-Bis(4'-diethyl-aminobenzylidene)-N-methyl-piperidone (0.5) | N-Phenyl glycine (5) |

- to be cont'd -

- cont'd -

| Crosslinking auxiliary (parts) | Stabilizer (parts) | Characteristics | |
|---|---|---|---|
| | | Sensitivity | Elongation |
| - | p-t-Butylcatechol (0.5) | Good | Good |
| - | - | do. | do. |
| - | p-t-Butylcatechol (0.5) | do. | do. |
| - | do. (0.5) | do. | do. |
| - | do. (0.5) | do. | do. |

- to be cont'd -

- cont'd -

| | | | |
|---|---|---|---|
| 26 | P-10 (100) | 3,5-Bis(4'-diethyl-aminobenzylidene)-N-methyl-piperidone (1) | N-Phenyl glycine (5) |
| 27 | P-10 (100) | do. (2) | do. (5) |
| 28 | P-11 (100) | Michler's ketone (3) | Pentaerythritol tetrathioglycolate (5) |
| 29 | P-12 (100) | 3,5-Bis(4'-diethyl-aminobenzylidene)-N-methyl-piperidone (1) | N-(4-Cyanophenyl)-glycine (5) |
| 30 | P-13 (100) | 2,4-Dimethyl thioxanthone (2) | Ethyl 4-diethyl-aminobenzoate (8) |
| 31 | P-14 (100) | 3,3'-Carbonyl bis(7-diethylamino)coumarin (2) | do. (5) |
| 32 | P-15 (100) | 3,5-Bis(4'-diethyl-aminobenzylidene)-N-methyl-piperidone (0.5) | Thioglicolic acid (5) |

- to be cont'd -

- cont'd -

| | | | |
|---|---|---|---|
| Ethylene glycol diacrylate (5) | 2,6-Di-tert-butyl-phenol (0.5) | Good | Good |
| Pentaerythritol diacrylate (15) | do. (0.5) | do. | do. |
| - | p-t-Butylcatechol (2) | do. | do. |
| - | 2,6-Di-tert-butyl-phenol (0.5) | do. | do. |
| - | - | do. | do. |
| - | 2,6-Di-tert-butyl-phenol (0.5) | do. | do. |
| - | do. (0.5) | do. | do. |

- to be cont'd -

- cont'd -

| | | | |
|---|---|---|---|
| 33 | P-16 (100) | 3,5-Bis(4'-diethyl-aminobenzylidene)-N-methyl-piperidone (0.5) | N-Phenylglycine (5) |
| 34 | P-17 (100) | 2-(p-Dimethylamino-styryl)quinoline (0.5) | do. (5) |
| 35 | P-19 (100) | Michler's ketone (3) | Pentaerythitol tetrathioglycolate (3) |
| 36 | P-20 (100) | 3,5-Bis(4'-diethyl-aminobenzylidene)-N-methyl-piperidone (5) | N-(4-Cyanophenyl)-glycine (10) |
| 37 | P-5 (100) | Riboflavine tetrabutyrate (2) | Ethyl 4-diethyl-aminobenzoate (8) |
| 38 | P-12 (100) | 3,3'-Carbonyl bis(7-diethylamino)-coumarin (2) | N-Phenylglycine (5) |

- to be cont'd -

- cont'd -

| | | | |
|---|---|---|---|
| Ethylene glycol diacrylate (10) | do. (1) | Good | Good |
| Pentaerythritol diacrylate (5) | - | do. | do. |
| - | p-t-Buthylcatechol (1) | do. | do. |
| - | 2,6-Di-tert-butyl-phenol (0.5) | do. | do. |
| - | do. (0.5) | do. | do. |
| - | do. (0.5) | do. | do. |

- to be cont'd -

- cont'd -

| | | | |
|---|---|---|---|
| 39 | P-12 (100) | 2-Methyl-1-[4-(methylthio)phenyl]-2-morphorinopropane-1-one (3) | N-Phenylglycine (6) |
| 40 | P-12 (100) | 3,5-Bis(4'-dimethylaminobenzylidene)-N-methyl-piperidone (1) | 4-Dimethylaminobenzonitrile (5) |

- to be cont'd -

- cont'd -

| | | | |
|---|---|---|---|
| — | 2,6-Di-tert-butyl-phenol (0.5) | Good | Good |
| Ethylene glycol diacrylate (5) | do. (0.5) | do. | do. |

Comparative Example 1

To 20 g of the poly(amic acid) solution synthesized in Example 1, 20 mg of 2,6-di-tert-butylphenol was added and 1.55 g (0.01 mole) of 2-(methacryloyloxy)ethyl isocyanate was added and allowed to stand at room temperature. After 2 days, the solution gelled.

Comparative Example 2

To 32.2 parts of benzophenonetetracarboxylic dianhydride dissolved in 50 parts by volume of γ-butyrolactone, 26 parts of hydroxyethyl methacrylate and a catalytic amount of 1,4-diazabicyclo(2,2,2)octane

were added. After reacting for 16 hours, a solution obtained by dissolving 16 parts of 4,4'-diaminodiphenyl ether in 50 parts by volume of N-methyl-2-pyrrolidone was added. Then, a solution obtained by dissolving 36 parts of dicyclohexylcarbodiimide in 100 parts by volume of $\gamma$-butyrolactone was added dropwise to the reaction solution. The reaction solution was allowed to stand at room temperature overnight, followed by filtration of a precipitate to give a photo-sensitive varnish.

The resulting varnish was spin coated on a silicon wafer, followed by heating at 200° C for 30 minutes and 400° C for 30 minutes to finally obtain a polyimide film of 8 $\mu$m thick.

The resulting film was brittle and the elongation was 1% or less.

As mentioned above, according to the present invention, the photo-sensitive heat resistant polymer composition can finally provide with high sensitivity a polyimide film excellent in mechanical properties due to introduction of a large amount of photo-sensitive groups into the high polymeric poly(amic acid). Such a polymer composition is suitable for forming a protection film of LSI, an $\alpha$-rays shielding film, an interlevel insulating film of thin film multi-level circuit board in computers and the like.

## Claims

1. A photo-sensitive polymer composition for forming fine patterns comprising

   (a) a polymer obtained by the reaction of a poly(amic acid) having as a major component repeating units of the formula:

   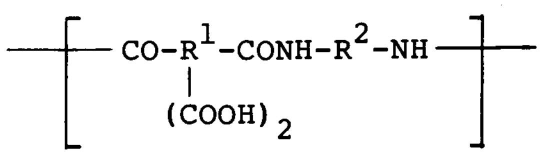

   ..... (1)

   wherein $R^1$ is a tetravelent organic group having at least 4 carbon atoms; $R^2$ is a divalent organic group, with one or more amino compounds having at least one hydroxy group and an isocyanate compound having at least one carbon-carbon unsaturated bonding, and

   (b) one or more photosensitizers or photoinitiators or photocrosslinkers.

2. A photo-sensitive polymer composition according to Claim 1, wherein $R^1$ and $R^2$ in the formula (1) are different.

3. A photo-sensitive polymer composition according to Claim 1 or 2, wherein the amounts of the amino compound having at least one hydroxy group, the isocyanate compound having at least one carbon-carbon unsaturated bonding, and the photosensitizer or photoinitiator or photocrosslinker are 1 to 400 parts, 1 to 400 parts, and 0.1 to 30 parts by weight per 100 parts by weight of poly(amic acid), respectively.

4. A photo-sensitive polymer composition according to Claim 1 or 2, wherein the amino compound having at least one hydroxy group is a compound of the formula:

   $R^3R^4N\text{-}R^5OH$ (2)

   wherein $R^3$ and $R^4$ are independently hydrogen, an alkyl group, a phenyl group, a benzyl group, or, $-R^5OH$; $R^5$ is a divalent organic group; a compound of the formula:

   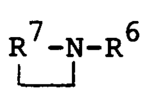

   ..... (3)

   wherein $R^6$ is hydrogen, an alkyl group, a phenyl group, a benzyl group, or $-R^5OH$; $R^7$ is a divalent organic group forming a cyclic amino moiety with a nitrogen atom, and one or both of $R^5$ and $R^7$ may be substituted with at least one hydroxyl group.

**5.** A photo-sensitive polymer composition according to Claim 1 or 2, wherein the isocyanate compound having at least one carbon-carbon unsaturated bonding is a compound of the formula:

$$R^8R^9C{=}\overset{\displaystyle R^{10}}{\overset{|}{C}}{-}CO{-}R^{11}{-}N{=}C{=}O \qquad \cdots\cdots \quad (4)$$

wherein $R^8$, $R^9$ and $R^{10}$ are independently hydrogen, an alkyl group, a phenyl group, a vinyl group, or a propenyl group; and $R^{11}$ is a divalent organic group.

**6.** A photo-sensitive polymer composition according to Claim 1 or 2, which further comprises one or more co-photosensitizers.

**7.** A photo-sensitive polymer composition according to Claim 1, 2, or 6, which further comprises one or more photopolymerizable co-monomers.

**8.** A photo-sensitive polymer composition according to Claim 1, 2, 6, or 7, which further comprises one or more stabilizers and/or inhibitors.

**9.** A photo-sensitive polymer composition according to Claim 1, 2, 6, 7, or 8, which further comprises one or more solvents in which the component (a) and the component (b) are dissolved, said solvent comprising one or more aprotic polar solvents.

**10.** A polymer obtained by reacting a poly(amic acid) having repeating units of the formula:

$$-\!\!\left[\, CO{-}\underset{\displaystyle (COOH)_2}{\underset{|}{R^1}}{-}CONH{-}R^2{-}NH \,\right]\!\!- \qquad \cdots\cdots \quad (1)$$

wherein $R^1$ is a tetravalent organic group having at least 4 carbon atoms; and $R^2$ is a divalent organic group, with an amino compound of the formula:

$R^3R^4N{-}R^5{-}OH$ (2)

wherein $R^3$ and $R^4$ are independently hydrogen, an alkyl group, a phenyl group, a benzyl group, or $-R^5OH$; and $R^5$ is a divalent organic group, and an isocyanate compound of the formula:

$$R^8R^9C{=}\overset{\displaystyle R^{10}}{\overset{|}{C}}{-}CO_2{-}R^{11}{-}N{=}C{=}O \qquad \cdots\cdots \quad (4)$$

wherein $R^8$, $R^9$ and $R^{10}$ are independently hydrogen, an alkyl group, a phenyl group, a vinyl group, or a propenyl group; and $R^{11}$ is a divalent organic group.

**11.** A polymer obtained by reacting a poly(amic acid) having repeating units of the formula:

$$-\!\!\left[\, CO{-}\underset{\displaystyle (COOH)_2}{\underset{|}{R^1}}{-}CONH{-}R^2{-}NH \,\right]\!\!- \qquad \cdots\cdots \quad (1)$$

wherein $R^1$ is a tetravalent organic group having at least 4 carbon atoms; and $R^2$ is a divalent organic group, with an amino compound of the formula:

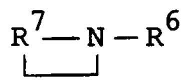

..... (3)

wherein $R^6$ is hydrogen, an alkyl group, a phenyl group, a benzyl group, or $-R^5OH$; $R^5$ is a divalent organic group; and $R^7$ is a divalent organic group forming a cyclic amino moiety with a nitrogen atom, and an isocyanate compound of the formula:

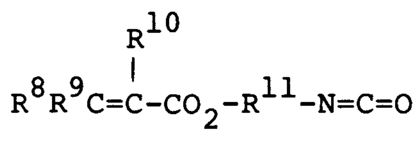

..... (4)

wherein $R^8$, $R^9$ and $R^{10}$ are independently hydrogen, an alkyl group, a phenyl group, a vinyl group, or a propenyl group; and $R^{11}$ is a divalent organic group.

European Patent Office

# EUROPEAN SEARCH REPORT

Application Number

EP 91113382.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US - A - 4 954 601 (KING) * Claims * -- | 1,5 | G 03 F 7/038<br>C 08 G 18/81<br>C 08 G 73/10 |
| D,Y | DE - A - 3 424 216 (GENERAL ELECTRIC) * Claims * & JP-A-60-100 143 -- | 1,5, 9-11 | |
| A | WO - A - 90/05 382 (BREWER SCIENCE) * Claims * -- | 1,5 | |
| A | EP - A - 0 355 927 (ASAHI KASEI KOGYO) * Claims; page 24, lines 51-58 * ---- | 1,6,7, 9,10 | |

TECHNICAL FIELDS SEARCHED (Int. Cl.5)

G 03 F
C 08 F
C 08 G

The present search report has been drawn up for all claims

| Place of search | Date of completion of the search | Examiner |
|---|---|---|
| VIENNA | 03-01-1992 | SCHÄFER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)